# EUROPEAN PATENT SPECIFICATION

(11) **EP 4 462 633 B1**
(45) Date of publication and mention of the grant of the patent: **04.11.2026**
(21) Application number: 23835721.4
(22) Date of filing: 22.06.2023
(51) Int. Cl.: H01M 10/44, H01M 10/48, G01R 31/3835, H02J 7/00, H02J 7/50, H02J 7/96

(54) **BATTERY SYSTEM FOR SEQUENTIAL CHARGING OF BATTERIES AND CONTROL METHOD THEREOF**
BATTERIESYSTEM ZUM SEQUENZIELLEN LADEN VON BATTERIEN UND STEUERUNGSVERFAHREN DAFÜR
SYSTÈME DE BATTERIE POUR CHARGE SÉQUENTIELLE DE BATTERIES ET PROCÉDÉ DE COMMANDE ASSOCIÉ

(30) Priority: 06.07.2022 KR 20220082964
(43) Date of publication of application: 13.11.2024
(73) Proprietor: LG Energy Solution, Ltd., Seoul 07335 (KR)
(72) Inventor: CHOI, Moon Gyu, Daejeon 34122 (KR); BANG, Ji Won, Daejeon 34122 (KR); EOM, Ji Hye, Daejeon 34122 (KR)
(74) Representative: Plasseraud IP
(86) International application number: PCT/KR2023/008702
(87) International publication number: WO 2024/010254

(56) References cited:
- EP-A2- 3 197 006
- JP-A- 2011 019 387
- KR-A- 20110 015 881
- KR-A- 20120 056 752
- KR-A- 20170 087 821
- US-A1- 2020 235 588
- US-A1- 2022 032 777

## Description

### [Technical Field]

This application claims priority to and the benefit of Korean Patent Application No. 10-2022-0082964 filed in the Korean Intellectual Property Office on July 6, 2022.

The present invention relates to a battery system and a control method thereof, and more particularly, to a battery system, a battery control device, and a control method of a battery system for sequentially charging batteries having different voltages.

### [Background Art]

A secondary battery is a battery that can be reused through charging even after being discharged, can be used as an energy source for a small device such as a mobile phone, a tablet PC and a vacuum cleaner, and is also used as an energy source for mid-size and large-size devices such as an automobile and an ESS (Energy Storage System) for a smart grid.

The secondary battery is applied to a system in a form of an assembly such as a battery module in which a plurality of battery cells are connected in series and parallel or a battery pack in which battery modules are connected in series and parallel, depending on system requirements. In the case of mid-size and large-size devices such as an electric vehicle, a high-capacity battery system in which a plurality of battery packs are connected in parallel may be applied so as to satisfy a required capacity of the corresponding device.

In the high-capacity battery system in which the plurality of battery packs are configured as such, when a new battery pack is additionally installed to expand a capacity or when an abnormality occurs in some of the battery packs, high voltage differences may occur among the battery packs. At this time, when the battery packs are charged using a general charging method, charging efficiency may be lowered, a battery lifetime may be reduced, and some components of the battery system may be damaged.

Accordingly, there is a need for an appropriate control technique for charging battery packs exhibiting high voltage differences. US 2020235588 discloses a discharging process by updating a group of battery packs.

### [Detailed Description of the Invention]

### [Technical Problem]

The present invention has been made in an effort to provide a battery system for sequentially charging batteries.

The present invention has also been made in an effort to provide a control method of the battery system.

The present invention has also been made in an effort to provide a battery control device for controlling an operation of the battery system.

### [Technical Solution]

The present invention is defined in the appended claims.

The battery control device is configured to determine a charging group by selecting one or more battery packs having a voltage value within a predefined threshold range, and to control the battery packs included in the charging group to be charged together up to a predefined target voltage. Here, the battery control device may be configured, when charging up to the target voltage is completed, to update the charging group by selecting, among battery packs in which charging is not in progress, a battery pack whose voltage value is within a predefined threshold range from a voltage value of the charging group.

The battery control device may be configured to determine a first battery pack having the lowest voltage value among the plurality of battery packs, to select a second battery pack whose voltage value difference from the first battery pack is equal to or less than a preset first threshold value, and to determine the first and second battery packs as the charging group.

The battery control device may be configured, when the charging group is charged up to the target voltage, to update the charging group by selecting, among the battery packs in which charging is not in progress, a third battery pack whose voltage value is equal to or greater than the voltage value of the charging group and voltage value difference from the charging group is equal to or less than a preset second threshold value and adding the selected third battery pack to the charging group.

The battery control device may be configured to select, among the battery packs in which charging is not in progress, a fourth battery pack whose voltage value is less than the voltage value of the charging group and voltage value difference from the charging group is equal to or less than a preset third threshold value and to add the selected fourth battery pack to the charging group.

The third threshold value may be defined based on at least one of a measurement error range of a voltage measurement device configured to measure a voltage value of a battery pack and a data processing speed of the battery control device.

The third threshold value may be defined as a value equal to or greater than a maximum measurement error value of the voltage measurement device and equal to or less than the second threshold value.

The third threshold may be defined as a value equal to or greater than a maximum value of a rising voltage during data processing time for updating the charging group and equal to or less than the second threshold value.

The present invention also provides a control method of a battery system as defined in the appended claims.

The determining of the charging group may include determining a first battery pack having the lowest voltage value among the plurality of battery packs; selecting a second battery pack whose voltage value difference from the first battery pack is equal to or less than a preset first threshold value; and determining the first and second battery packs as the charging group.

The updating of the charging group may include selecting, among the battery packs in which charging is not in progress, a third battery pack whose voltage value is equal to or greater than the voltage value of the charging group and voltage value difference from the charging group is equal to or less than a preset second threshold value; and adding the selected third battery pack to the charging group.

The updating of the charging group may include selecting, among the battery packs in which charging is not in progress, a fourth battery pack whose voltage value is less than the voltage value of the charging group and voltage value difference from the charging group is equal to or less than a preset third threshold value; and adding the selected fourth battery pack to the charging group.

The third threshold value may be defined as a value equal to or greater than a maximum measurement error value of a voltage measurement device and equal to or less than the second threshold value.

The third threshold may be defined as a value equal to or greater than a maximum value of a rising voltage during data processing time for updating the charging group and equal to or less than the second threshold value.

The present invention also provides a battery control device located in a battery system as defined in the appended claims.

Here, the at least one command includes a command to collect voltage values for each of the plurality of battery packs; a command to determine a charging group by selecting one or more battery packs having a voltage value within a predefined threshold range; a command to control battery packs included in the charging group to be charged together to a predefined target voltage; and a command, when charging up to the target voltage is completed, to update the charging group by selecting, among battery packs in which charging is not in progress, a battery pack whose voltage value is within a predefined threshold range from a voltage value of the charging group.

The command to determine the charging group may include a command to determine a first battery pack having the lowest voltage value among the plurality of battery packs; a command to select a second battery pack whose voltage value difference from the first battery pack is equal to or less than a preset first threshold value; and a command to determine the first and second battery packs as the charging group.

The command to update the charging group may include a command to select, among the battery packs in which charging is not in progress, a third battery pack whose voltage value is equal to or greater than the voltage value of the charging group and voltage value difference from the charging group is equal to or less than a preset second threshold value; and a command to add the selected third battery pack to the charging group.

The command to update the charging group may include a command to select, among the battery packs in which charging is not in progress, a fourth battery pack whose voltage value is less than the voltage value of the charging group and voltage value difference from the charging group is equal to or less than a preset third threshold value; and a command to add the selected fourth battery pack to the charging group.

The third threshold value may be defined as a value equal to or greater than a maximum measurement error value of a voltage measurement device and equal to or less than the second threshold value.

The third threshold may be defined as a value equal to or greater than a maximum value of a rising voltage during data processing time for updating the charging group and equal to or less than the second threshold value.

### [Advantageous Effects]

According to exemplary embodiments of the present invention, it is possible to effectively charge the battery packs exhibiting high voltage differences by grouping and sequentially charging battery packs having a voltage value within a certain range.

### [Brief Description of the Drawings]

FIG. 1 is a block configuration diagram for illustrating a battery system according to an embodiment of the present invention.
FIG. 2 is an operation flowchart of a control method of a battery system according to an embodiment of the present invention.
FIG. 3 shows an example of battery packs exhibiting voltage differences.
FIG. 4 is a reference diagram for illustrating a method of controlling charging of the battery packs shown in FIG. 3, according to an embodiment of the present invention.
FIG. 5 is a reference diagram for illustrating a method of updating a charging group of the battery packs shown in FIG. 3, according to an embodiment of the present invention.
FIG. 6 is a block configuration diagram of a battery control device according to an embodiment of the present invention.

- 100:: battery pack
- 200:: battery control device
- 600:: battery control device

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power, and a battery module refers to an assembly in which a plurality of battery cells are electrically connected.

A battery pack or battery rack refers to a system with a minimum single structure that can be monitored and controlled through a battery management system (BMS) by electrically connecting module units set by a battery manufacturer, and may include several battery modules and one battery protection unit (BPU) or protection device.

A battery bank may refer to an assembly group of large-scale battery rack systems configured by connecting a plurality of battery racks in parallel. Monitoring and control of a rack BMS (RBMS) of a battery rack unit can be performed through the BMS of a battery bank unit.

A battery assembly includes a plurality of electrically connected battery cells, and refers to an assembly that functions as a power supply source by being applied to a specific system or device. Here, the battery assembly may mean a battery module, a battery pack, a battery rack, a battery bank or the like, but the scope of the present invention is not limited to these entities.

A state of charge (SOC) is a current charged state of a battery expressed as a percentage [%], and a state of health (SOH) is a current remaining state of a battery expressed as a percentage [%].

A nominal capacity (nominal capa.) may mean a set capacity [Ah] of a battery set by a battery manufacturer during development.

Hereinafter, preferred embodiments of the present invention will be described in detail with reference to the drawings.

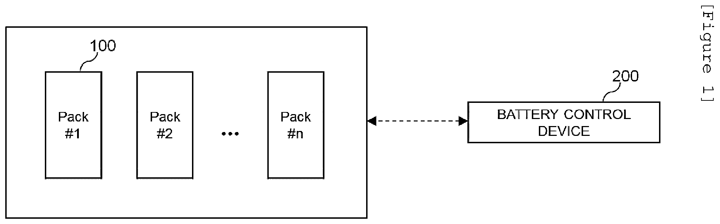

FIG. 1 is a block configuration diagram for illustrating a battery system according to an embodiment of the present invention.

Referring to FIG. 1, the battery system includes a battery assembly including a plurality of battery packs 100 and a battery control device 200.

The plurality of battery packs 100 may be connected to each other in parallel to constitute a battery assembly.

The battery system according to an embodiment of the present invention may be included and implemented in an electric vehicle, but the scope of the present invention is not limited to the entity. That is, the battery system according to an embodiment of the present invention may be applied to a device having a plurality of battery packs and may be configured to control charging of the battery packs exhibiting voltage differences through a control operation described below.

The battery control device 200 may be included and implemented in a BMS located inside the battery system.

The battery control device 200 may be configured to collect voltage values for each of the plurality of battery packs 100 and to control charging of the plurality of battery packs, based on the collected voltage values. Here, the battery control device 200 may be configured to control charging of each battery pack in a manner of controlling a charging circuit connected to each of the plurality of battery packs 100 (for example, ON/OFF control of a relay circuit).

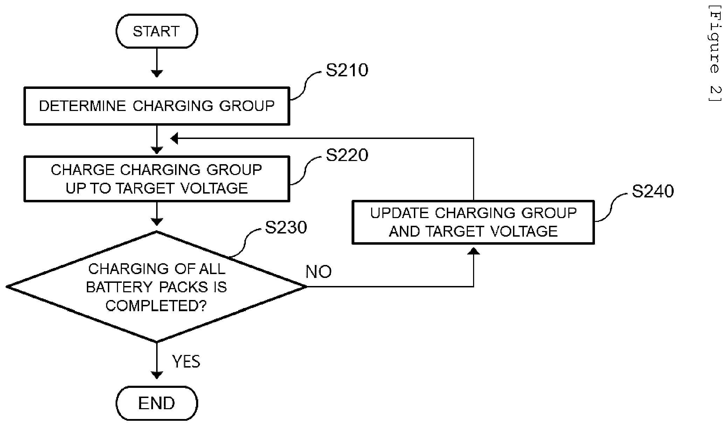

Hereinafter, operations of the battery system and the battery control device 200 according to an embodiment of the present invention will be described in detail with reference to FIGS. 2 to 5.

FIG. 2 is an operation flowchart of a control method of a battery system according to an embodiment of the present invention.

The battery control device 200 collects voltage values for each of a plurality of battery packs. Here, the battery control device 200 may collect the voltage values of the battery packs for each preset unit time (for example, 1 second) or predefined time point (for example, determination or update time point of a charging group).

The battery control device 200 determines a charging group including some of the plurality of battery packs, based on the voltage values for each of the plurality of battery packs (S210).

Here, the battery control device 200 may select one or more battery packs having a voltage value within a predefined threshold range and determine the selected battery packs as a charging group. Meanwhile, when the selected battery pack is a battery pack determined as being in an abnormal state, the battery pack in the abnormal state may be excluded from the charging group.

Thereafter, the battery control device 200 controls the battery packs included in the charging group determined in S210 to be charged together up to a predefined target voltage (S220). Here, the target voltage may be defined as the lowest value among the voltage values of the respective battery packs not included in the charging group.

When the battery packs included in the charging group are charged up to the target voltage, the battery control device 200 checks whether charging of all the battery packs is completed (S230).

When all the battery packs are not completely charged (NO in S230), the battery control device 200 updates the charging group determined in S210 and the target voltage (S240).

Here, the battery control device 200 may update the charging group by selecting a battery pack whose voltage value is within a predefined threshold range from a voltage value of the charging group among battery packs in which charging is not in progress (i.e., battery packs not included in the charging group) and including the selected battery pack in the charging group. Meanwhile, when the selected battery pack is a battery pack determined as being in an abnormal state, the battery pack in the abnormal state may be excluded from the charging group. In addition, the battery control device 200 may update the currently set target voltage to the lowest value among the voltage values of the respective battery packs not included in the updated charging group.

Thereafter, the battery control device 200 controls the battery packs included in the updated charging group to be charged together up to the updated target voltage (S220).

As shown in FIG. 2, the process of sequentially updating and charging the charging group may be repeatedly performed until charging of all the battery packs is completed (YES in S230).

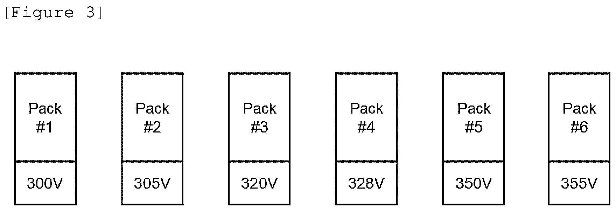

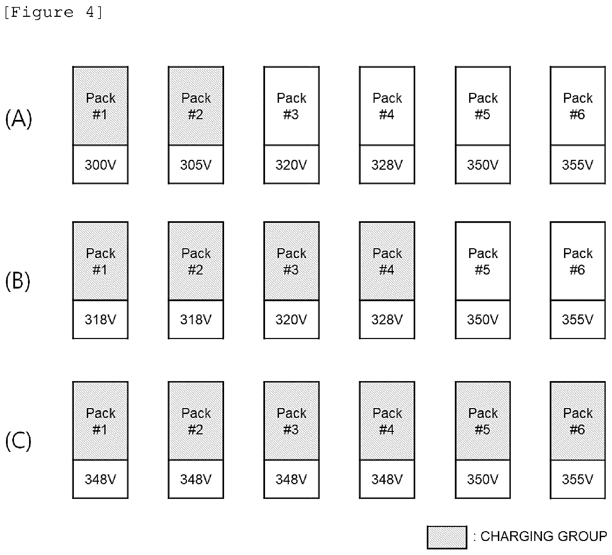

FIG. 3 shows an example of battery packs exhibiting voltage differences, and FIG. 4 is a reference diagram for illustrating a method of controlling charging of the battery packs shown in FIG. 3, according to an embodiment of the present invention. Hereinafter, a control method of a battery system according to an embodiment of the present invention will be described in detail, taking the battery packs shown in FIG. 3 as an example.

The battery packs included in the battery system shown in FIG. 3 are in a state of having different voltage values, respectively. As shown in FIG. 3, battery packs #1 to #6 are in a state of having voltage values of 300 V, 305 V, 320 V, 328 V, 350 V, and 355 V, respectively.

The battery control device 200 determines a first battery pack having the lowest voltage value among the plurality of battery packs. Also, the battery control device 200 selects a second battery pack whose voltage value difference from the first battery pack is equal to or less than a preset first threshold value. Thereafter, the battery control device 200 determines the first and second battery packs as a charging group.

For example, referring to FIG. 4(A), the battery control device 200 determines the battery pack #1 exhibiting the lowest voltage value (300V) among the battery packs #1 to #6, as the first battery pack. When the first threshold value is defined as 10V, the battery control device 200 determines the battery pack #2 exhibiting a voltage value of 310V or lower, as the second battery pack, and determines the battery packs #1 and #2 as a charging group.

The battery control device 200 controls the battery packs included in the charging group to be charged together up to a predefined target voltage. Here, the target voltage may be defined as the lowest value among the voltage values of the respective battery packs not included in the charging group.

For example, referring to FIG. 4(A), the target voltage may be defined as 320V, which is the lowest value among the voltage values of the battery packs #3 to #6 not included in the charging group. The battery control device 200 controls the charging group (battery packs #1 and #2) to be charged up to the target voltage of 320V.

On the other hand, even when the battery pack is charged up to the set target voltage, the voltage of the battery pack may not reach the target voltage because the target voltage is a maximum voltage of a battery cell included in the battery pack. For example, as shown in FIG. 4(B), when the charging of the battery packs #1 and #2 up to the target voltage of 320V is completed, the battery packs #1 and #2 may be in a state of having a voltage value of 318V, which is equal to or lower than the target voltage of 320V.

When the charging group is charged up to the target voltage, the battery control device 200 selects, among battery packs in which charging is not in progress, a third battery pack whose voltage value is equal to or greater than the voltage value of the charging group and voltage value difference from the charging group is equal to or less than a preset second threshold value. Thereafter, the battery control device 200 updates the charging group by adding the selected third battery pack to the charging group. Also, the battery control device 200 updates the currently set target voltage to the lowest value among the voltage values of the respective battery packs not included in the updated charging group.

For example, when the second threshold value is defined as 10V, as shown in FIG. 4(B), the battery control device 200 updates the charging group (battery packs #1 to #4) by selecting the battery packs #3 and #4 exhibiting voltage values of 318V or higher and 328V or lower among the battery packs #3 to #6, as the third battery pack, and including the battery packs #3 and #4 in the charging group. In addition, the battery control device 200 updates the currently set target voltage (320V) to 350V, which is the lowest value among the voltage values of the battery packs #5 and #6 not included in the updated charging group.

The battery control device 200 controls the battery packs included in the updated charging group to be charged together up to the updated target voltage.

For example, referring to FIG. 4(C), the battery control device 200 controls the charging group (battery packs #1 to #4) to be charged up to the target voltage of 350V. Here, when the charging of the battery packs #1 to #4 up to the target voltage (350V) is completed, the battery packs #1 to #4 may be in a state of having a voltage value of 348V, which is equal to or lower than the target voltage (350V).

After completion of the charging up to the target voltage, the battery control device 200 determines the battery packs #5 and #6 exhibiting voltage values of 348V or higher and 358V or lower among the battery packs #5 and #6, as the third battery pack, and updates the charging group (battery packs #1 to #6) by including the battery packs #5 and #6 in the charging group.

When there is no battery pack not included in the updated charging group, the battery control device 200 may update the currently set target voltage to the highest value among the voltage values of the respective battery packs included in the updated charging group. For example, the battery control device 200 may update the currently set target voltage(350V) to 355V, which is the highest value among the voltage values of the battery packs #1 to #6 included in the updated charging group.

When the charging up to the updated target voltage (355V) is completed, the charging of all the battery packs is completed, and therefore, the charging process ends.

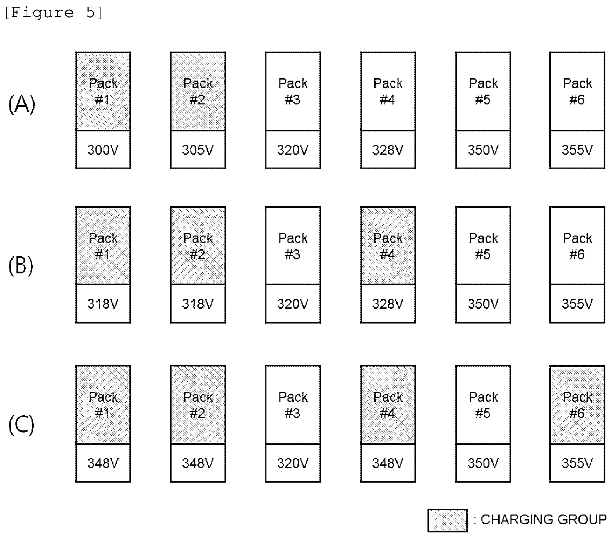

FIG. 5 is a reference diagram for illustrating a method of updating a charging group of the battery packs shown in FIG. 3, according to an embodiment of the present invention.

The battery control device 200 according to an embodiment of the present invention determines or updates a charging group, based on measured voltages value of battery packs. Here, when the measurement accuracy of a voltage measurement device is low or when a data processing speed of the system is slow, a problem that some of the battery packs to be included in the charging group are missed may occur.

For example, in FIG. 5(B), when the charging of the charging group (battery packs #1 and #2) is completed, the battery control device 200 selects, among the battery packs #3 to #6, a third battery pack whose voltage value is equal to or greater than the voltage value of the charging group and voltage value difference from the charging group is equal to or less than 10V (second threshold value), for update of the charging group.

Here, when the voltage measurement device has a certain measurement error range (for example, -4V to +4V), the voltage values of the battery packs #1 and #2 may be measured as 321V although the actual voltage values of the battery packs #1 and #2 are 318V. In this case, the battery control device 200 may add the battery pack #4 exhibiting a voltage value of 321V or higher and 331V or lower among the battery packs #3 to #6 to the charging group, and the battery pack #3 that should be included in the charging group may be missed.

Also, when the battery system is implemented as a low-performance system, the charging group update process may be delayed after the charging of the battery packs #1 and #2 is completed. In this case, during the data processing time for updating the charging group, the voltages of the battery packs #1 and #2 may be increased to 319V by the minute charging current. In this case, the battery control device 200 may add the battery pack #4 exhibiting a voltage value of 319V or higher and 329V or lower among the battery packs #3 to #6 to the charging group, and the battery pack #3 that should be included in the charging group may be missed.

When updating the charging group, the battery control device 200 may perform an operation according to an embodiment below so that a battery pack to be included in the charging group is not missed due to the measurement performance of the voltage measurement device and the data processing speed of the battery system.

When the charging group is charged up to the target voltage, the battery control device 200 selects, among battery packs in which charging is not in progress, a fourth battery pack whose voltage value is less than the voltage value of the charging group and voltage value difference from the charging group is equal to or less than a preset third threshold value. Thereafter, the battery control device 200 adds the selected fourth battery pack to the charging group.

For example, in FIG. 5(B), when the voltages of the battery packs #1 and #2 are measured as 321V after the charging of the battery packs #1 and #2 is completed, the battery control device 200 adds the battery pack #4 exhibiting a voltage value of 321V or higher and 331V or lower among the battery packs #1 to #6 to the charging group. Also, when the third threshold value is defined as 5V, the battery control device 200 adds the battery pack #3 exhibiting a voltage value of 316V or higher and lower than 321V to the charging group. According to the present embodiment, both the battery packs #3 and #4 can be included in the charging group to be updated.

The third threshold value may be defined based on at least one of a measurement error range of the voltage measurement device and a data processing speed of the battery control device.

In an embodiment, the third threshold value may be defined as a value equal to or greater than a maximum measurement error value of the voltage measurement device and equal to or less than the second threshold value. For example, when the second threshold value is 10V and the measurement error range of the voltage measurement device is -4 V to +4 V, the third threshold value may be defined as a value equal to or greater than 4 and equal to or less than 10.

In another embodiment, the third threshold value may be defined as a value equal to or greater than a maximum value of a rising voltage during data processing time for updating the charging group and equal to or less than the second threshold value. Here, the maximum value of the rising voltage may be defined through a pre-test for the charging group update process. For example, when the second threshold value is 10V and the maximum value of the rising voltage during the data processing time for updating the charging group is 1V, the third threshold value may be defined as a value equal to or greater than 1 and equal to or less than 10.

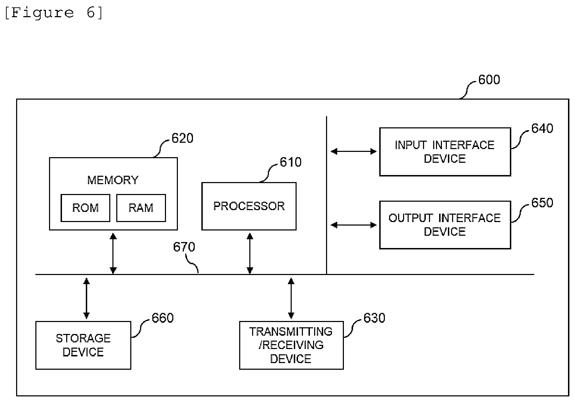

FIG. 6 is a block configuration diagram of a battery control device according to an embodiment of the present invention.

A battery control device 600 according to an embodiment of the present invention is located in a battery system including a plurality of battery packs, and may include at least one processor 610, a memory 620 configured to store at least one command that is executed through the processor, and a transmitting/receiving device 630 connected to a network and configured to perform communication.

The at least one command may include a command to collect voltage values for each of the plurality of battery packs; a command to determine a charging group by selecting one or more battery packs having a voltage value within a predefined threshold range; a command to control battery packs included in the charging group to be charged together to a predefined target voltage; and a command, when charging up to the target voltage is completed, to update the charging group by selecting, among battery packs in which charging is not in progress, a battery pack whose voltage value is within a predefined threshold range from a voltage value of the charging group.

The command to determine the charging group may include a command to determine a first battery pack having the lowest voltage value among the plurality of battery packs; a command to select a second battery pack whose voltage value difference from the first battery pack is equal to or less than a preset first threshold value; and a command to determine the first and second battery packs as the charging group.

The command to update the charging group may include a command to select, among the battery packs in which charging is not in progress, a third battery pack whose voltage value is equal to or greater than the voltage value of the charging group and voltage value difference from the charging group is equal to or less than a preset second threshold value; and a command to add the selected third battery pack to the charging group.

The command to update the charging group may include a command to select, among the battery packs in which charging is not in progress, a fourth battery pack whose voltage value is less than the voltage value of the charging group and voltage value difference from the charging group is equal to or less than a preset third threshold value; and a command to add the selected fourth battery pack to the charging group.

The third threshold value may be defined as a value equal to or greater than a maximum measurement error value of the voltage measurement device and equal to or less than the second threshold value.

The third threshold value may be defined as a value equal to or greater than a maximum value of a rising voltage during data processing time for updating the charging group and equal to or less than the second threshold value.

The battery control device 600 may further include an input interface device 640, an output interface device 650, a storage device 660, and the like. The respective components included in the battery control device 600 may be connected by a bus 670 and configured to perform communication with each other.

Here, the processor 610 may mean a central processing unit (CPU), a graphics processing unit (GPU), or a dedicated processor on which methods according to embodiments of the present invention are performed. The memory (or storage device) may be configured by at least one of a volatile storage medium and a non-volatile storage medium. For example, the memory may be configured by at least one of a read only memory (ROM) and a random access memory (RAM).

Operations according to embodiments of the present invention can be embodied as a computer-readable program or code on a computer-readable recording medium. The computer-readable recording medium includes all types of recording media in which data readable by a computer system is stored. In addition, the computer-readable recording medium may be distributed over computer systems connected through a network so that a computer-readable program or code may be stored and executed in a distributed manner.

Some aspects of the present invention have been described above in the context of a device but may be described using a method corresponding thereto. Here, blocks or the device corresponds to operations of the method or characteristics of the operations of the method. Similarly, aspects of the present invention described above in the context of a method may be described using blocks or items corresponding thereto or characteristics of a device corresponding thereto. Some or all of the operations of the method may be performed, for example, by (or using) a hardware device such as a microprocessor, a programmable computer or an electronic circuit. In some embodiments, one or more of most important operations of the method may be performed by such a device.

## Claims

1. A battery system comprising:
a plurality of battery packs (100); and
a battery control device (200, 600) configured to collect voltage values for each of the plurality of battery packs (100) and to control charging of the plurality of battery packs (100), based on the collected voltage values,
wherein the battery control device (200, 600) is configured:
to determine (S210) a charging group by selecting one or more battery packs (100) having a voltage value within a predefined threshold range, to control the battery packs (100) included in the charging group to be charged together up to a predefined target voltage, and when charging (S220) up to the target voltage is completed, to update (S240) the target voltage and the charging group by selecting, among battery packs (100) in which charging is not in progress, i.e among battery packs (100) not included in the charging group, a battery pack (100) whose voltage value is within a predefined threshold range from a voltage value of the charging group, and to include the selected battery pack (100) in the charging group by adding the selected battery pack (100) to the charging group, and to thereafter control the battery packs included in the updated charging group to be charged together up to the updated target voltage (S220).

2. The battery system of claim 1, wherein the battery control device (200, 600) is configured to determine a first battery pack (100) having the lowest voltage value among the plurality of battery packs (100), to select a second battery pack (100) whose voltage value difference from the first battery pack (100) is equal to or less than a preset first threshold value, and to determine the first and second battery packs (100) as the charging group.

3. The battery system of claim 1, wherein the battery control device (200, 600) is configured, when the charging group is charged up to the target voltage, to update the charging group by selecting, among the battery packs (100) in which charging is not in progress, a third battery pack (100) whose voltage value is equal to or greater than the voltage value of the charging group and voltage value difference from the charging group is equal to or less than a preset second threshold value and adding the selected third battery pack (100) to the charging group.

4. The battery system of claim 3, wherein the battery control device (200, 600) is configured to select, among the battery packs (100) in which charging is not in progress, a fourth battery pack (100) whose voltage value is less than the voltage value of the charging group and voltage value difference from the charging group is equal to or less than a preset third threshold value and to add the selected fourth battery pack (100) to the charging group.

5. The battery system of claim 4, wherein the third threshold value is defined based on at least one of a measurement error range of a voltage measurement device configured to measure a voltage value of a battery pack (100) and a data processing speed of the battery control device (200, 600).

6. The battery system of claim 5, wherein the third threshold value is defined as a value equal to or greater than a maximum measurement error value of the voltage measurement device and equal to or less than the second threshold value.

7. The battery system of claim 5, wherein the third threshold value is defined as a value equal to or greater than a maximum value of a rising voltage during data processing time for updating the charging group and equal to or less than the second threshold value.

8. A control method of a battery system comprising a plurality of battery packs (100), and a battery control device (200, 600), the control method comprising:
collecting, by the battery control device (200, 600), voltage values for each of the plurality of battery packs (100);
determining (S210), by the battery control device (200, 600), a charging group by selecting one or more battery packs (100) having a voltage value within a predefined threshold range;
controlling (S220), by the battery control device (200, 600), the battery packs (100) included in the charging group to be charged together up to a predefined target voltage; and
when charging up to the target voltage is completed, updating (S240), by the battery control device (200, 600), the target voltage and the charging group by selecting, among battery packs (100) in which charging is not in progress, i.e among battery packs (100) not included in the charging group, a battery pack (100) whose voltage value is within a predefined threshold range from a voltage value of the charging group, and including the selected battery pack (100) in the charging group by adding the selected battery pack (100) to the charging group, and thereafter controlling the battery packs included in the updated charging group to be charged together up to the updated target voltage (S220).

9. The control method of claim 8, wherein the determining of the charging group comprises:
determining a first battery pack (100) having the lowest voltage value among the plurality of battery packs (100);
selecting a second battery pack (100) whose voltage value difference from the first battery pack (100) is equal to or less than a preset first threshold value; and
determining the first and second battery packs (100) as the charging group.

10. The control method of claim 8, wherein the updating of the charging group comprises:
selecting, among the battery packs (100) in which charging is not in progress, a third battery pack (100) whose voltage value is equal to or greater than the voltage value of the charging group and voltage value difference from the charging group is equal to or less than a preset second threshold value; and
adding the selected third battery pack (100) to the charging group.

11. The control method of claim 10, wherein the updating of the charging group comprises:
selecting, among the battery packs (100) in which charging is not in progress, a fourth battery pack (100) whose voltage value is less than the voltage value of the charging group and voltage value difference from the charging group is equal to or less than a preset third threshold value; and
adding the selected fourth battery pack (100) to the charging group.

12. The control method of claim 11, wherein the third threshold value is defined as a value equal to or greater than a maximum measurement error value of a voltage measurement device and equal to or less than the second threshold value.

13. The control method of claim 11, wherein the third threshold value is defined as a value equal to or greater than a maximum value of a rising voltage during data processing time for updating the charging group and equal to or less than the second threshold value.

14. A battery control device located in a battery system comprising a plurality of battery packs (100), the battery control device (200, 600) comprising:
at least one processor (610); and
a memory (620) configured to store at least one command that is executed by the at least one processor (610),
wherein the at least one command comprises:
a command to collect voltage values for each of the plurality of battery packs (100);
a command to determine (S210) a charging group by selecting one or more battery packs (100) having a voltage value within a predefined threshold range;
a command to control (S220) battery packs (100) included in the charging group to be charged together to a predefined target voltage; and
a command, when charging up to the target voltage is completed, to update (S240) the target voltage and the charging group by selecting, among battery packs (100) in which charging is not in progress, i.e among battery packs (100) not included in the charging group, a battery pack (100) whose voltage value is within a predefined threshold range from a voltage value of the charging group, and to include the selected battery pack (100) in the charging group by adding the selected battery pack (100) to the charging group, and to thereafter control the battery packs included in the updated charging group to be charged together up to the updated target voltage (S220).

15. The battery control device of claim 14, wherein the command to determine the charging group comprises:
a command to determine a first battery pack (100) having the lowest voltage value among the plurality of battery packs (100);
a command to select a second battery pack (100) whose voltage value difference from the first battery pack (100) is equal to or less than a preset first threshold value; and
a command to determine the first and second battery packs (100) as the charging group.

## Patentansprüche

1. Batteriesystem, umfassend:
eine Vielzahl von Batteriepacks (100); und
eine Batteriesteuervorrichtung (200, 600), die konfiguriert ist, um Spannungswerte für jedes der Vielzahl von Batteriepacks (100) zu sammeln und um das Laden der Vielzahl von Batteriepacks (100) basierend auf den gesammelten Spannungswerten zu steuern,
wobei die Batteriesteuervorrichtung (200, 600) konfiguriert ist:
um eine Ladegruppe zu bestimmen (S210), indem ein oder mehrere Batteriepacks (100) mit einem Spannungswert innerhalb eines vordefinierten Schwellenbereichs ausgewählt werden, um die in der Ladegruppe enthaltenen Batteriepacks (100) so zu steuern, dass sie gemeinsam bis zu einer vordefinierten Zielspannung geladen werden, und wenn das Laden (S220) bis zur Zielspannung abgeschlossen ist, um die Zielspannung und die Ladegruppe zu aktualisieren (S240), indem aus Batteriepacks (100), bei denen das Laden nicht im Gange ist, d. h. aus Batteriepacks (100), die nicht in der Ladegruppe enthalten sind, ein Batteriepack (100) ausgewählt wird, dessen Spannungswert innerhalb eines vordefinierten Schwellenbereichs von einem Spannungswert der Ladegruppe liegt, und um das ausgewählte Batteriepack (100) in die Ladegruppe aufzunehmen, indem das ausgewählte Batteriepack (100) der Ladegruppe hinzugefügt wird, und um danach die in der aktualisierten Ladegruppe enthaltenen Batteriepacks so zu steuern, dass sie gemeinsam bis zur aktualisierten Zielspannung (S220) geladen werden.

2. Das Batteriesystem nach Anspruch 1, wobei die Batteriesteuervorrichtung (200, 600) konfiguriert ist, um ein erstes Batteriepack (100) mit dem niedrigsten Spannungswert unter der Vielzahl von Batteriepacks (100) zu bestimmen, um ein zweites Batteriepack (100) auszuwählen, dessen Spannungswertdifferenz zum ersten Batteriepack (100) gleich oder kleiner als ein erster voreingestellter Schwellenwert ist, und um das erste und das zweite Batteriepack (100) als die Ladegruppe zu bestimmen.

3. Das Batteriesystem nach Anspruch 1, wobei die Batteriesteuervorrichtung (200, 600) so konfiguriert ist, dass sie, wenn die Ladegruppe bis zur Zielspannung geladen ist, die Ladegruppe aktualisiert, indem sie aus den Batteriepacks (100), bei denen das Laden nicht im Gange ist, ein drittes Batteriepack (100) auswählt, dessen Spannungswert gleich oder größer als der Spannungswert der Ladegruppe ist und dessen Spannungswertdifferenz zur Ladegruppe gleich oder kleiner als ein zweiter voreingestellter Schwellenwert ist, und das ausgewählte dritte Batteriepack (100) der Ladegruppe hinzufügt.

4. Das Batteriesystem nach Anspruch 3, wobei die Batteriesteuervorrichtung (200, 600) so konfiguriert ist, dass sie aus den Batteriepacks (100), bei denen das Laden nicht im Gange ist, ein viertes Batteriepack (100) auswählt, dessen Spannungswert kleiner als der Spannungswert der Ladegruppe ist und dessen Spannungswertdifferenz zur Ladegruppe gleich oder kleiner als ein dritter voreingestellter Schwellenwert ist, und das ausgewählte vierte Batteriepack (100) der Ladegruppe hinzufügt.

5. Das Batteriesystem nach Anspruch 4, wobei der dritte Schwellenwert auf der Grundlage von mindestens einem von einem Messfehlerbereich einer Spannungsmessvorrichtung, die zum Messen eines Spannungswertes eines Batteriepacks (100) konfiguriert ist, und einer Datenverarbeitungsgeschwindigkeit der Batteriesteuervorrichtung (200, 600) definiert ist.

6. Das Batteriesystem nach Anspruch 5, wobei der dritte Schwellenwert als ein Wert definiert ist, der gleich oder größer als ein maximaler Messfehlerwert der Spannungsmessvorrichtung und gleich oder kleiner als der zweite Schwellenwert ist.

7. Das Batteriesystem nach Anspruch 5, wobei der dritte Schwellenwert als ein Wert definiert ist, der gleich oder größer als ein Maximalwert einer ansteigenden Spannung während einer Datenverarbeitungszeit zum Aktualisieren der Ladegruppe und gleich oder kleiner als der zweite Schwellenwert ist.

8. Steuerverfahren für ein Batteriesystem, das eine Vielzahl von Batteriepacks (100) und eine Batteriesteuervorrichtung (200, 600) umfasst, wobei das Steuerverfahren umfasst:
das Sammeln von Spannungswerten für jedes der Vielzahl von Batteriepacks (100) durch die Batteriesteuervorrichtung (200, 600);
das Bestimmen (S210) einer Ladegruppe durch die Batteriesteuervorrichtung (200, 600) durch Auswählen eines oder mehrerer Batteriepacks (100) mit einem Spannungswert innerhalb eines vordefinierten Schwellenbereichs;
das Steuern (S220) der in der Ladegruppe enthaltenen Batteriepacks (100) durch die Batteriesteuervorrichtung (200, 600), so dass sie gemeinsam bis zu einer vordefinierten Zielspannung geladen werden; und
wenn das Laden bis zur Zielspannung abgeschlossen ist, das Aktualisieren (S240) der Zielspannung und der Ladegruppe durch die Batteriesteuervorrichtung (200, 600) durch Auswählen eines Batteriepacks (100), dessen Spannungswert innerhalb eines vordefinierten Schwellenbereichs von einem Spannungswert der Ladegruppe liegt, aus Batteriepacks (100), bei denen das Laden nicht im Gange ist, d. h. aus Batteriepacks (100), die nicht in der Ladegruppe enthalten sind, und das Einbeziehen des ausgewählten Batteriepacks (100) in die Ladegruppe durch Hinzufügen des ausgewählten Batteriepacks (100) zur Ladegruppe, und danach
das Steuern der in der aktualisierten Ladegruppe enthaltenen Batteriepacks, so dass sie gemeinsam bis zur aktualisierten Zielspannung (S220) geladen werden.

9. Das Steuerverfahren nach Anspruch 8, wobei das Bestimmen der Ladegruppe umfasst:
das Bestimmen eines ersten Batteriepacks (100) mit dem niedrigsten Spannungswert unter der Vielzahl von Batteriepacks (100);
das Auswählen eines zweiten Batteriepacks (100), dessen Spannungswertdifferenz zum ersten Batteriepack (100) gleich oder kleiner als ein erster voreingestellter Schwellenwert ist; und
das Bestimmen des ersten und zweiten Batteriepacks (100) als die Ladegruppe.

10. Das Steuerverfahren nach Anspruch 8, wobei das Aktualisieren der Ladegruppe umfasst:
das Auswählen, aus den Batteriepacks (100), bei denen das Laden nicht im Gange ist, eines dritten Batteriepacks (100), dessen Spannungswert gleich oder größer als der Spannungswert der Ladegruppe ist und dessen Spannungswertdifferenz zur Ladegruppe gleich oder kleiner als ein zweiter voreingestellter Schwellenwert ist; und
das Hinzufügen des ausgewählten dritten Batteriepacks (100) zur Ladegruppe.

11. Das Steuerverfahren nach Anspruch 10, wobei das Aktualisieren der Ladegruppe umfasst:
das Auswählen, aus den Batteriepacks (100), bei denen das Laden nicht im Gange ist, eines vierten Batteriepacks (100), dessen Spannungswert kleiner als der Spannungswert der Ladegruppe ist und dessen Spannungswertdifferenz zur Ladegruppe gleich oder kleiner als ein dritter voreingestellter Schwellenwert ist; und
das Hinzufügen des ausgewählten vierten Batteriepacks (100) zur Ladegruppe.

12. Das Steuerverfahren nach Anspruch 11, wobei der dritte Schwellenwert als ein Wert definiert ist, der gleich oder größer als ein maximaler Messfehlerwert einer Spannungsmessvorrichtung und gleich oder kleiner als der zweite Schwellenwert ist.

13. Das Steuerverfahren nach Anspruch 11, wobei der dritte Schwellenwert als ein Wert definiert ist, der gleich oder größer als ein Maximalwert einer ansteigenden Spannung während einer Datenverarbeitungszeit zum Aktualisieren der Ladegruppe und gleich oder kleiner als der zweite Schwellenwert ist.

14. Batteriesteuervorrichtung, die sich in einem Batteriesystem befindet, das eine Vielzahl von Batteriepacks (100) umfasst, wobei die Batteriesteuervorrichtung (200, 600) umfasst:
mindestens einen Prozessor (610); und
einen Speicher (620), der so konfiguriert ist, dass er mindestens einen Befehl speichert, der von dem mindestens einen Prozessor (610) ausgeführt wird,
wobei der mindestens eine Befehl umfasst:
einen Befehl zum Sammeln von Spannungswerten für jedes der Vielzahl von Batteriepacks (100);
einen Befehl zum Bestimmen (S210) einer Ladegruppe durch Auswählen eines oder mehrerer Batteriepacks (100) mit einem Spannungswert innerhalb eines vordefinierten Schwellenbereichs;
einen Befehl zum Steuern (S220) der in der Ladegruppe enthaltenen Batteriepacks (100), so dass sie gemeinsam bis zu einer vordefinierten Zielspannung geladen werden; und
einen Befehl, um, wenn das Laden bis zur Zielspannung abgeschlossen ist, die Zielspannung und die Ladegruppe zu aktualisieren (S240), indem aus Batteriepacks (100), bei denen das Laden nicht im Gange ist, d. h. aus Batteriepacks (100), die nicht in der Ladegruppe enthalten sind, ein Batteriepack (100) ausgewählt wird, dessen Spannungswert innerhalb eines vordefinierten Schwellenbereichs von einem Spannungswert der Ladegruppe liegt, und um das ausgewählte Batteriepack (100) in die Ladegruppe aufzunehmen, indem das ausgewählte Batteriepack (100) der Ladegruppe hinzugefügt wird, und um danach die Batteriepacks zu steuern,
die in der aktualisierten Ladegruppe enthalten sind, so dass sie gemeinsam bis zur aktualisierten Zielspannung (S220) geladen werden.

15. Die Batteriesteuervorrichtung nach Anspruch 14, wobei der Befehl zum Bestimmen der Ladegruppe umfasst:
einen Befehl zum Bestimmen eines ersten Batteriepacks (100) mit dem niedrigsten Spannungswert unter der Vielzahl von Batteriepacks (100);
einen Befehl zum Auswählen eines zweiten Batteriepacks (100), dessen Spannungswertdifferenz zum ersten Batteriepack (100) gleich oder kleiner als ein erster voreingestellter Schwellenwert ist; und
einen Befehl zum Bestimmen des ersten und zweiten Batteriepacks (100) als die Ladegruppe.

## Revendications

1. Système de batterie comprenant :
une pluralité de blocs-batteries (100) ; et
un dispositif de commande de batterie (200, 600) configuré pour collecter des valeurs de tension pour chacun de la pluralité de blocs-batteries (100) et pour commander la charge de la pluralité de blocs-batteries (100), sur la base des valeurs de tension collectées,
dans lequel le dispositif de commande de batterie (200, 600) est configuré :
pour déterminer (S210) un groupe de charge en sélectionnant un ou plusieurs blocs-batteries (100) ayant une valeur de tension dans une plage de seuil prédéfinie, pour commander les blocs-batteries (100) inclus dans le groupe de charge pour qu'ils soient chargés ensemble jusqu'à une tension cible prédéfinie, et lorsque la charge (S220) jusqu'à la tension cible est terminée, pour mettre à jour (S240) la tension cible et le groupe de charge en sélectionnant, parmi les blocs-batteries (100) dans lesquels la charge n'est pas en cours, c'est-à-dire parmi les blocs-batteries (100) non inclus dans le groupe de charge, un bloc-batterie (100) dont la valeur de tension est dans une plage de seuil prédéfinie par rapport à une valeur de tension du groupe de charge, et pour inclure le bloc-batterie sélectionné (100) dans le groupe de charge en ajoutant le bloc-batterie sélectionné (100) au groupe de charge, et pour commander ensuite les blocs-batteries inclus dans le groupe de charge mis à jour pour qu'ils soient chargés ensemble jusqu'à la tension cible mise à jour (S220).

2. Le système de batterie selon la revendication 1, dans lequel le dispositif de commande de batterie (200, 600) est configuré pour déterminer un premier bloc-batterie (100) ayant la valeur de tension la plus basse parmi la pluralité de blocs-batteries (100), pour sélectionner un deuxième bloc-batterie (100) dont la différence de valeur de tension par rapport au premier bloc-batterie (100) est égale ou inférieure à une première valeur de seuil préréglée, et pour déterminer les premier et deuxième blocs-batteries (100) comme étant le groupe de charge.

3. Le système de batterie selon la revendication 1, dans lequel le dispositif de commande de batterie (200, 600) est configuré, lorsque le groupe de charge est chargé jusqu'à la tension cible, pour mettre à jour le groupe de charge en sélectionnant, parmi les blocs-batteries (100) dans lesquels la charge n'est pas en cours, un troisième bloc-batterie (100) dont la valeur de tension est égale ou supérieure à la valeur de tension du groupe de charge et dont la différence de valeur de tension par rapport au groupe de charge est égale ou inférieure à une deuxième valeur de seuil préréglée, et en ajoutant le troisième bloc-batterie sélectionné (100) au groupe de charge.

4. Le système de batterie selon la revendication 3, dans lequel le dispositif de commande de batterie (200, 600) est configuré pour sélectionner, parmi les blocs-batteries (100) dans lesquels la charge n'est pas en cours, un quatrième bloc-batterie (100) dont la valeur de tension est inférieure à la valeur de tension du groupe de charge et dont la différence de valeur de tension par rapport au groupe de charge est égale ou inférieure à une troisième valeur de seuil préréglée, et pour ajouter le quatrième bloc-batterie sélectionné (100) au groupe de charge.

5. Le système de batterie selon la revendication 4, dans lequel la troisième valeur de seuil est définie sur la base d'au moins l'un d'une plage d'erreur de mesure d'un dispositif de mesure de tension configuré pour mesurer une valeur de tension d'un bloc-batterie (100) et d'une vitesse de traitement de données du dispositif de commande de batterie (200, 600).

6. Le système de batterie selon la revendication 5, dans lequel la troisième valeur de seuil est définie comme une valeur égale ou supérieure à une valeur d'erreur de mesure maximale du dispositif de mesure de tension et égale ou inférieure à la deuxième valeur de seuil.

7. Le système de batterie selon la revendication 5, dans lequel la troisième valeur de seuil est définie comme une valeur égale ou supérieure à une valeur maximale d'une tension montante pendant un temps de traitement de données pour la mise à jour du groupe de charge et égale ou inférieure à la deuxième valeur de seuil.

8. Procédé de commande d'un système de batterie comprenant une pluralité de blocs-batteries (100), et un dispositif de commande de batterie (200, 600), le procédé de commande comprenant :
la collecte, par le dispositif de commande de batterie (200, 600), de valeurs de tension pour chacun de la pluralité de blocs-batteries (100) ;
la détermination (S210), par le dispositif de commande de batterie (200, 600), d'un groupe de charge en sélectionnant un ou plusieurs blocs-batteries (100) ayant une valeur de tension dans une plage de seuil prédéfinie ;
la commande (S220), par le dispositif de commande de batterie (200, 600), des blocs-batteries (100) inclus dans le groupe de charge pour qu'ils soient chargés ensemble jusqu'à une tension cible prédéfinie ; et
lorsque la charge jusqu'à la tension cible est terminée, la mise à jour (S240), par le dispositif de commande de batterie (200, 600), de la tension cible et du groupe de charge en sélectionnant, parmi les blocs-batteries (100) dans lesquels la charge n'est pas en cours, c'est-à-dire parmi les blocs-batteries (100) non inclus dans le groupe de charge, un bloc-batterie (100) dont la valeur de tension est dans une plage de seuil prédéfinie par rapport à une valeur de tension du groupe de charge, et l'inclusion du bloc-batterie sélectionné (100) dans le groupe de charge en ajoutant le bloc-batterie sélectionné (100) au groupe de charge, et ensuite
la commande des blocs-batteries inclus dans le groupe de charge mis à jour pour qu'ils soient chargés ensemble jusqu'à la tension cible mise à jour (S220).

9. Le procédé de commande selon la revendication 8, dans lequel la détermination du groupe de charge comprend :
la détermination d'un premier bloc-batterie (100) ayant la valeur de tension la plus basse parmi la pluralité de blocs-batteries (100) ;
la sélection d'un deuxième bloc-batterie (100) dont la différence de valeur de tension par rapport au premier bloc-batterie (100) est égale ou inférieure à une première valeur de seuil préréglée ; et
la détermination des premier et deuxième blocs-batteries (100) comme étant le groupe de charge.

10. Le procédé de commande selon la revendication 8, dans lequel la mise à jour du groupe de charge comprend :
la sélection, parmi les blocs-batteries (100) dans lesquels la charge n'est pas en cours, d'un troisième bloc-batterie (100) dont la valeur de tension est égale ou supérieure à la valeur de tension du groupe de charge et dont la différence de valeur de tension par rapport au groupe de charge est égale ou inférieure à une deuxième valeur de seuil préréglée ; et
l'ajout du troisième bloc-batterie sélectionné (100) au groupe de charge.

11. Le procédé de commande selon la revendication 10, dans lequel la mise à jour du groupe de charge comprend :
la sélection, parmi les blocs-batteries (100) dans lesquels la charge n'est pas en cours, d'un quatrième bloc-batterie (100) dont la valeur de tension est inférieure à la valeur de tension du groupe de charge et dont la différence de valeur de tension par rapport au groupe de charge est égale ou inférieure à une troisième valeur de seuil préréglée ; et
l'ajout du quatrième bloc-batterie sélectionné (100) au groupe de charge.

12. Le procédé de commande selon la revendication 11, dans lequel la troisième valeur de seuil est définie comme une valeur égale ou supérieure à une valeur d'erreur de mesure maximale d'un dispositif de mesure de tension et égale ou inférieure à la deuxième valeur de seuil.

13. Le procédé de commande selon la revendication 11, dans lequel la troisième valeur de seuil est définie comme une valeur égale ou supérieure à une valeur maximale d'une tension montante pendant un temps de traitement de données pour la mise à jour du groupe de charge et égale ou inférieure à la deuxième valeur de seuil.

14. Dispositif de commande de batterie situé dans un système de batterie comprenant une pluralité de blocs-batteries (100), le dispositif de commande de batterie (200, 600) comprenant :
au moins un processeur (610) ; et
une mémoire (620) configurée pour stocker au moins une instruction qui est exécutée par l'au moins un processeur (610),
dans lequel l'au moins une instruction comprend :
une instruction pour collecter des valeurs de tension pour chacun de la pluralité de blocs-batteries (100) ;
une instruction pour déterminer (S210) un groupe de charge en sélectionnant un ou plusieurs blocs-batteries (100) ayant une valeur de tension dans une plage de seuil prédéfinie ;
une instruction pour commander (S220) les blocs-batteries (100) inclus dans le groupe de charge pour qu'ils soient chargés ensemble jusqu'à une tension cible prédéfinie ; et
une instruction, lorsque la charge jusqu'à la tension cible est terminée, pour mettre à jour (S240) la tension cible et le groupe de charge en sélectionnant, parmi les blocs-batteries (100) dans lesquels la charge n'est pas en cours, c'est-à-dire parmi les blocs-batteries (100) non inclus dans le groupe de charge, un bloc-batterie (100) dont la valeur de tension est dans une plage de seuil prédéfinie par rapport à une valeur de tension du groupe de charge, et pour inclure le bloc-batterie sélectionné (100) dans le groupe de charge en ajoutant le bloc-batterie sélectionné (100) au groupe de charge, et pour commander ensuite les blocs-batteries
inclus dans le groupe de charge mis à jour pour qu'ils soient chargés ensemble jusqu'à la tension cible mise à jour (S220).

15. Le dispositif de commande de batterie selon la revendication 14, dans lequel l'instruction pour déterminer le groupe de charge comprend :
une instruction pour déterminer un premier bloc-batterie (100) ayant la valeur de tension la plus basse parmi la pluralité de blocs-batteries (100) ;
une instruction pour sélectionner un deuxième bloc-batterie (100) dont la différence de valeur de tension par rapport au premier bloc-batterie (100) est égale ou inférieure à une première valeur de seuil préréglée ; et
une instruction pour déterminer les premier et deuxième blocs-batteries (100) comme étant le groupe de charge.
